# EUROPÄISCHE PATENTSCHRIFT

(11) **EP 2 915 017 B1**
(45) Veröffentlichungstag und Bekanntmachung des Hinweises auf die Patenterteilung: **11.04.2018**
(21) Anmeldenummer: 14741643.2
(22) Anmeldetag: 22.07.2014
(51) Int. Cl.: G06F 1/18, G06F 1/16

(54) **ANORDNUNG FÜR EIN COMPUTERSYSTEM**
ASSEMBLY FOR A COMPUTER SYSTEM
ARRANGEMENT POUR UN SYSTÈME INFORMATIQUE

(30) Priorität: 02.08.2013 DE 102013108363
(43) Veröffentlichungstag der Anmeldung: 09.09.2015
(73) Patentinhaber: Fujitsu Limited, Kawasaki-shi Kanagawa 211-8588 (JP)
(72) Erfinder: KARTHEININGER, Michael, 86199 Augsburg (DE)
(74) Vertreter: Epping - Hermann - Fischer
(86) Internationale Anmeldenummer: PCT/EP2014/065751
(87) Internationale Veröffentlichungsnummer: WO 2015/014675

(56) Entgegenhaltungen:
- DE-U1-202008 003 769
- US-A1- 2006 221 559
- US-B1- 7 101 188

## Beschreibung

Die Erfindung betrifft eine Anordnung für ein Computersystem, welche ein Gehäuse mit einem Gehäuseboden, ein Netzteil und eine Hauptplatine aufweist. Die Erfindung betrifft des Weiteren einen Winkelstecker zur Verwendung in einer solchen Anordnung.

Üblicherweise wird eine Hauptplatine eines Servereinschubs zur Stromversorgung an ein Netzteil elektrisch angeschlossen. Dabei wird das Netzteil, welches auch als Power Supply Unit (PSU) bezeichnet werden kann, in der Regel in einem Anschlussbereich der Hauptplatine an diese angeschlossen. Bevorzugt wird das Netzteil per Direktsteckung an die Hauptplatine angeschlossen.

Aus der DE 202008003769 U1 ist eine Zwischenvorrichtung zur Ausgabe eines steckbaren Energiesystems bekannt, die jeweils mit einem Ausgabeanschluss eines steckbaren Energiesystems mit einem Eingabeanschluss eines elektronischen Geräts verbunden ist.

Aus der US 2006/0221559 A1 ist ein zweidimensional justierbarer Winkeladapter bekannt. Der Winkeladapter weist ein Gehäuse und Kontakte auf, deren eine Seite konventionell und die andere Seite über ein leitendes Elastomer angeschlossen werden können.

Die US 7,101,188 B1 beschreibt einen elektrischen Kantenadapter. Der Kantenadapter umfasst eine Aufnahme für eine Verbindung mit einer Kante einer Karte und eine Verbindungskante mit einem Set oder mit Sets von Kontakten.

Eine Aufgabe, die der Erfindung zugrunde liegt, ist es, eine Anordnung für einen Servereinschub eines Serversystems sowie eine Vorrichtung anzugeben, welche einen einfach zu montierenden elektrischen Anschluss eines Netzteils an eine Hauptplatine ermöglichen.

Gemäß einem ersten Aspekt der Erfindung wird eine Anordnung für einen Servereinschub eines Serversystems beschrieben, welche ein Einschubgehäuse mit einem Gehäuseboden aufweist. An dem Gehäuseboden ist ein Netzteil mit einem Steckkontakt angeordnet. Innerhalb des Einschubgehäuses ist parallel zu dem Gehäuseboden eine Hauptplatine angeordnet. Zudem weist die Anordnung einen Winkelstecker auf, welcher zum Anschluss des Netzteils an die Hauptplatine einen Gegensteckkontakt und einen Anschlussbereich aufweist, wobei der Winkelstecker beim Anschluss an die Hauptplatine mit dem Anschlussbereich in einer ersten Einbauhöhe der Hauptplatine an einer Oberseite der Hauptplatine und in einer zweiten Einbauhöhe der Hauptplatine in unterschiedlicher Ausrichtung, im Wesentlichen um 180° verdreht an einer Unterseite der Hauptplatine angeschlossen ist, so dass jeweils ein Höhenausgleich bezüglich einer ersten Mittelebene der Hauptplatine zu einer zweiten Mittelebene des Steckkontakts des Netzteils hergestellt ist. Hierbei sind die Einbauhöhen auf den jeweiligen Abstand der Hauptplatine zu dem Gehäuseboden in Normalenrichtung einer Erstreckungsebe der Hauptplatine bezogen.

Einschubgehäuse für Servereinschübe weisen in der Regel eine Gehäusehöhe von einer oder zwei Höheneinheiten (kurz HE, auch englisch Unit oder kurz U) auf und sind daher in ihren Abmessungen fest definiert. Die Netzteile weisen in der Regel einen fest vorgegebenen Formfaktor auf und sind in der Regel in einer festen Einbauposition in dem Einschubgehäuse angeordnet. Dies bedingt, dass der Steckkontakt des Netzteils im Wesentlichen stets einen gleichbleibenden Abstand zu dem Gehäuseboden des Einschubgehäuses aufweist.

Abhängig von dem jeweiligen Serversystem sind im Inneren des Einschubgehäuses unterschiedliche Komponenten, wie beispielsweise Riserkarten oder sonstige Steckkarten, angeordnet. Dies hat zur Folge, dass die Hauptplatinen in den jeweiligen Serversystemen unterschiedliche Abstände zu den Gehäuseböden einnehmen. Auch aufgrund anderer mechanischer Restriktionen, beispielsweise wegen Befestigungen von Slotwinkeln der Steckkarten an einem Slotfeld des Einschubgehäuses, weisen die Hauptplatinen unterschiedliche Abstände zu dem Gehäuseboden auf. Dadurch ist es nicht ohne Weiteres möglich, das Netzteil, dessen Steckkontakt in der Regel den gleichbleibenden Abstand zum Gehäuseboden aufweist, an Hauptplatinen mit unterschiedlichen Abständen zu dem Gehäuseboden mittels Direktsteckverbindung anzuschließen.

Die Anordnung gemäß dem ersten Aspekt sieht vor, dass das Netzteil über einen Winkelstecker direkt an der Hauptplatine angesteckt ist. Abhängig von einer ersten Einbauhöhe und einer zweiten Einbauhöhe kann der Winkelstecker mit dem Anschlussbereich entweder an die Oberseite oder die Unterseite der Hauptplatine angeschlossen werden, so dass ein Höhenausgleich zu dem Steckkontakt des Netzteils hergestellt ist. Der Winkelstecker kann somit in unterschiedlicher Ausrichtung, im Wesentlichen um 180° verdreht, an die Unter- oder Oberseite der Hauptplatine angeschlossen werden. Somit ist es möglich, ein und dasselbe Netzteil direkt an eine Hauptplatine anzustecken, welche in einer ersten oder zweiten Einbauhöhe bezüglich des Gehäusebodens innerhalb des Einschubgehäuses angeordnet sein kann. Hierzu besitzt der Winkelstecker einen Versatz zwischen dem Anschlussbereich und dem Gegensteckkontakt, mit welchem er einen Versatz zwischen der Hauptplatine und dem Steckkontakt des Netzteils kompensiert.

Unter Einbauhöhe wird im Wesentlichen der Abstand in Normalenrichtung einer Erstreckungsebene der Hauptplatine zu dem Gehäuseboden verstanden. Dabei muss die Einbauhöhe nicht zwingend einen bestimmten Wert einnehmen, sondern kann einen engen Toleranzbereich von beispielsweise bis zu 1 mm umfassen.

Somit ist es nicht notwendig, für die unterschiedlichen Serversysteme und Hauptplatinen mit unterschiedlichen Einbauhöhen separate Steckverbindungen vorzusehen. Zusätzlich können Kabel und/oder separate Zwischenboards vermieden werden. Des Weiteren ist eine solche Anordnung für das sogenannte Hot-Plugging geeignet. Unter Hot-Plugging wird die Möglichkeit verstanden, Einbau- oder Einschubkomponenten während des laufenden Betriebs eines (Server-)Systems auszutauschen oder auszuwechseln. Mithilfe des Winkelsteckers können somit Bauteilvarianten für die Direktsteckung der Netzteile reduziert werden. Dies führt zu einer einfachen Logistik und niedrigen Stückpreisen, da die Winkelstecker in hoher Stückzahl hergestellt werden können.

In anderen Worten ausgedrückt kompensiert der Winkelstecker einen Versatz zwischen einer ersten Mittelebene des Hauptplatine und einer zweiten Mittelebene des Steckkontakts des Netzteils derart, dass unabhängig von der ersten Einbauhöhe oder der zweiten Einbauhöhe der Hauptplatine der Steckkontakt des Netzteils in dem Gegensteckkontakt des Winkelstecker aufgenommen werden kann. Somit gleicht der Winkelstecker unterschiedliche Steck- oder Anschlussniveaus zwischen dem Netzteil und der Hauptplatine in zwei Einbauhöhen der Hauptplatine aus.

In anderen Worten ausgedrückt weist eine Oberfläche, welche parallel zu einer ersten Mittelebene der Hauptplatine dem Anschlussbereich im eingesteckten Zustand des Winkelsteckers zugewandt ist, im Wesentlichen einen gleichbleibenden Abstand zu einer parallel zu der ersten Mittelebene verlaufenden zweiten Mittelebene des Steckkontakts des Netzteils auf.

Gemäß einer weiteren Ausgestaltung weist die Hauptplatine zum Anschluss des Winkelsteckers einen Kontaktbereich, insbesondere metallisierte Öffnungen, auf, welcher an der Oberseite und an der Unterseite der Hauptplatine von dem Anschlussbereich des Winkelsteckers elektrisch kontaktiert werden kann. Auch werden die Montagekosten dadurch reduziert, da der Winkelstecker einfach und werkzeuglos montiert werden kann.

Gemäß einer weiteren Ausgestaltung weist der Anschlussbereich des Winkelsteckers zum Anschluss an die Hauptplatine Einpresskontakte, insbesondere Pressfit-Kontakte, auf. Die Einpresskontakte können besonders einfach in den Kontaktbereich, beispielsweise in die metallisierten Öffnungen, der Hauptplatine eingesteckt werden. Dies ist sowohl von einer Oberseite als von der Unterseite der Hauptplatine möglich. Durch Verwenden von Einpresskontakten, insbesondere Pressfit-Kontakten, entfällt durch die Durchsteckmontage durch Kontaktlöcher (englisch Through-Hole-Technology, kurz THT) ein Schwalllötvorgang zum Verlöten von Drahtkontakten oder -anschlüssen. Insbesondere ein Schwalllöten der Oberseite des Motherboards, für den Fall, dass die Drahtkontakte von der Unterseite in die Hauptplatine eingesteckt würden, wäre nur mit aufwendigen Mitteln und somit sehr kostspielig zu verwirklichen. Einpresskontakte dagegen sind einfach herzustellen und in der Montage günstig, da der Winkelstecker einfach und werkzeuglos montiert werden kann. Die Einpresskontakte müssen nicht in einem zusätzlichen Montageschritt verlötet werden, wodurch Zeit und Kosten eingespart werden.

Gemäß einer weiteren Ausgestaltung weist der Gegensteckkontakt des Winkelsteckers zur Aufnahme des Steckkontakts des Netzteils Federkontakte, insbesondere eine Federkontaktleiste, auf. Somit ist eine einfache Möglichkeit gegeben, das Netzteil direkt an den Winkelstecker anzuschließen. Durch das Vorsehen von Federkontakten ist es möglich, Fertigungstoleranzen und wie eingangs beschrieben Toleranzen bei der Einbauhöhe der Hauptplatine auszugleichen. Dies liegt daran, dass die Federkontakte in einem Toleranzbereich stets einen Kontakt zu dem Steckkontakt des Netzteils entsprechend ihrer Federkraft herstellen.

Gemäß einer weiteren Ausgestaltung weist der Steckkontakt des Netzteils wenigstens eine Kontaktzunge, insbesondere eine Goldkontaktzunge, auf. Somit ist eine einfache Ausgestaltung des Steckkontakts gegeben, welcher sich insbesondere für eine Direktsteckung und somit für das Hot-Plugging eignet.

Gemäß einer weiteren Ausgestaltung ist der Winkelstecker spiegelsymmetrisch ausgebildet. Dadurch ist es möglich, dass das Netzteil mit seinem Steckkontakt unabhängig von der Ausrichtung des Winkelsteckers korrekt an der Ober- oder Unterseite der Hauptplatine angeschlossen werden kann. Dies bedeutet, dass beispielsweise stets die richtigen Kontakte oder Pins des Netzteils mit den entsprechenden und dafür vorgesehenen Kontakten beziehungsweise Leiterbahnen der Hauptplatine verbunden sind.

Weitere Ausgestaltungen sind in der nachfolgenden, ausführlichen Beschreibung eines Ausführungsbeispiels offenbart.

Die Erfindung wird nachfolgend anhand des Ausführungsbeispiels unter Bezugnahme auf die angehängten Figuren näher erläutert.

Es zeigen:
- Figur 1: eine schematische Schnittansicht einer Anordnung für einen Servereinschub mit einer Hauptplatine in einer ersten Einbauhöhe,
- Figur 2: eine schematische Schnittansicht einer Anordnung für einen Servereinschub mit einer Hauptplatine in einer zweiten Einbauhöhe,
- Figur 3: eine perspektivische Ansicht eines Netzteil, und
- Figur 4: eine perspektivische Ansicht eines Winkelsteckers.

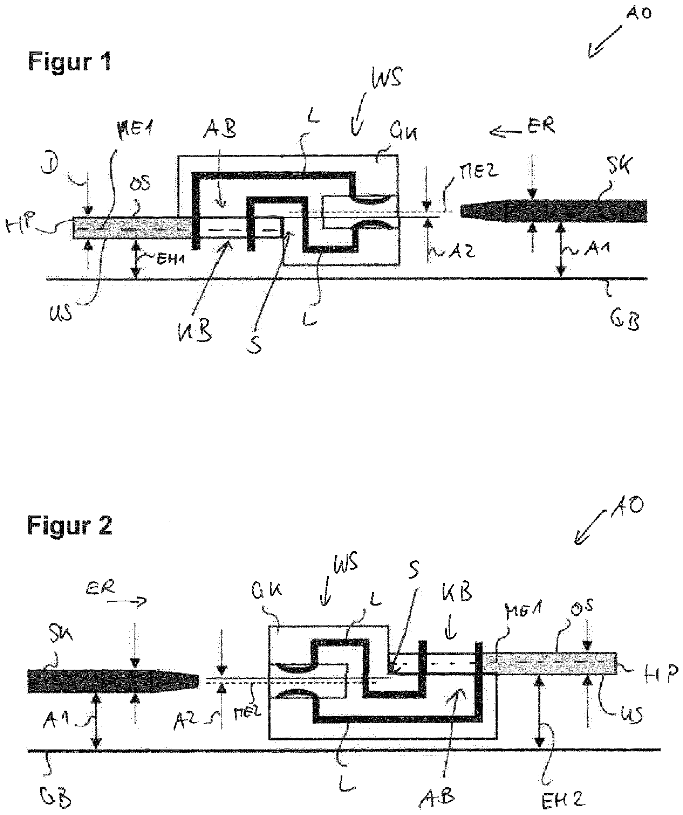

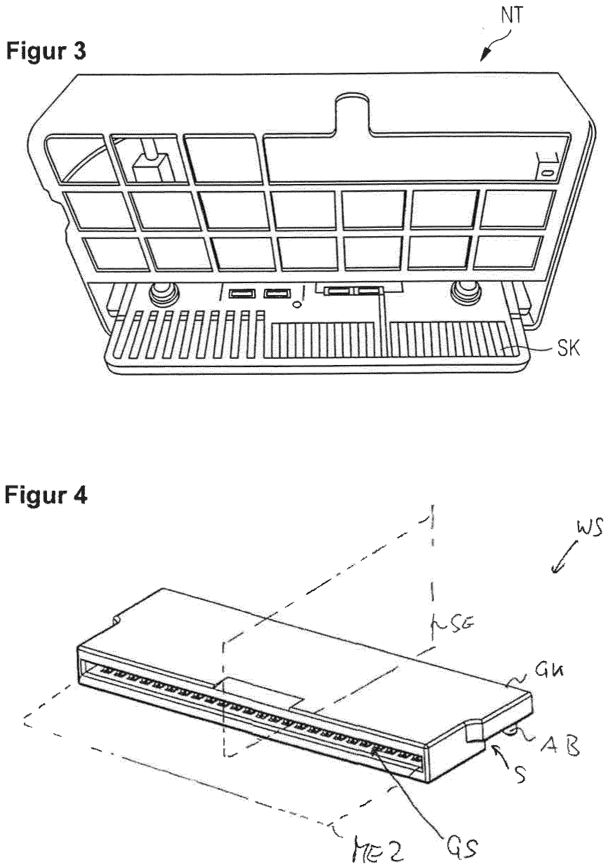

Die Figuren 1 und 2 zeigen schematische Schnitte von Anordnungen AO für einen Servereinschub eines Serversystems. Die Anordnungen AO weisen jeweils einen Gehäuseboden GB eines Einschubgehäuses auf. Die Anordnungen AO weisen des Weiteren einen Winkelstecker WS auf, welcher in einer konstruktiven Ausgestaltung perspektivisch in Figur 4 dargestellt ist. Die Anordnungen AO weisen des Weiteren ein in Figur 3 beispielhaft ausgestaltetes Netzteil NT mit einem Steckkontakt SK auf, welcher eine Kontaktzunge wie beispielsweise eine Goldkontaktzunge ist. Andere konstruktive Ausgestaltungen für das Netzteil NT und den Winkelstecker WS sind möglich.

Bei den Anordnungen AO ist eine Hauptplatine HP wie in Figur 1 gezeigt in einer ersten Einbauhöhe EH1 und wie in Figur 2 gezeigt in einer zweiten Einbauhöhe EH2 bezüglich des Gehäusebodens GB eingebaut. Unter den Einbauhöhen EH1 und EH2 ist ein Abstand einer Unterseite US der Hauptplatine HP zu dem Gehäuseboden GB in einer Normalenrichtung zu einer Erstreckungsebene des Gehäusebodens GB zu verstehen.

Der Winkelstecker WS besitzt einen Grundkörper GK, der an einer ersten Seite einen Gegensteckkontakt GS wie in Figur 4 dargestellt zum Anschluss an den Steckkontakt SK des Netzteils NT hat. Der Gegensteckkontakt GS ist als Federkontaktleiste ausgestaltet, welche mehrere Federkontakte zur Aufnahme der Kontaktzunge des Netzteils NT aufweist. Der Winkelstecker WS weist an einer zweiten Seite des Grundkörpers des Weiteren einen Anschlussbereich AB auf. Im Anschlussbereich AB sind Einpresskontakte, insbesondere Pressfit-Kontakte, angeordnet. Im Inneren des Grundkörpers GK sind die Pressfit-Kontakte und die Federkontakte über Leitungen L elektrisch verbunden. Weitere Details der elektrischen Verbindung im Inneren des Winkelsteckers WS sind nicht dargstellt.

Die Hauptplatine HP besitzt zum Anschluss des Winkelsteckers WS einen Kontaktbereich KB, in dem metallisierte Öffnungen angeordnet sind. Die Öffnungen sind dabei über eine Dicke D der Hauptplatine HP durchgängig in die Hauptplatine HP eingebracht. Somit ist es möglich, dass der Winkelstecker WS mit dem Anschlussbereich AB sowohl an eine Oberseite OS (siehe Figur 1) als auch an die Unterseite US (siehe Figur 2) der Hauptplatine HP angeschlossen und/oder angesteckt werden kann.

Wie eingangs erwähnt, weist das Netzteil NT einen in der Regel fest definierten Formfaktor auf und ist in dem Servereinschub derart angeordnet, dass der Steckkontakt SK einen festen ersten Abstand A1 zu dem Gehäuseboden GB des Servereinschubs hat. Somit hat Steckkontakt SK in den Anordnungen AO gemäß den Figuren 1 und 2 einen im Wesentlichen gleichen ersten Abstand A1, beispielsweise 4,3 mm, zu dem Gehäuseboden GB, welcher analog zu den Einbauhöhen EH1 und EH2 definiert ist.

Die unterschiedlichen Einbauhöhen EH1 und EH2 der Hauptplatinen HP gemäß den Figuren 1 und 2 können aus den mechanischen Restriktionen wie eingangs beschrieben resultieren. Die erste Einbauhöhe EH1 kann beispielsweise ein Abstand zum Gehäuseboden GB von 3 mm sein. Die zweite Einbauhöhe EH2 kann beispielsweise ein Abstand zu dem Gehäuseboden von 5,6 mm sein. Somit besteht zwischen einer ersten Mittelebene ME1 der Hauptplatine HP und einer zweiten Mittelebene ME2 des Steckkontakts SK des Netzteils NT in beiden Anordnungen AO der Figuren 1 und 2 ein Versatz (englisch Offset). Somit haben der Kontaktbereich KB der Hauptplatine HP und der Steckkontakt SK des Netzteils NT ein unterschiedliches Steckniveau.

Der Versatz zwischen der ersten Mittelebene ME1 und der zweiten Mittelebene ME2 wird nun mittels des Winkelsteckers WS ausgeglichen. Dabei ist der Winkelstecker WS gemäß Figur 1 mit dem Anschlussbereich AB an die Oberseite OS der Hauptplatine HP im Kontaktbereich KB angeschlossen. Der Gegensteckkontakt GS des Winkelsteckers WS ist dabei im Wesentlichen derart angeordnet, dass der Versatz zwischen den beiden Mittelebenen ME1 und ME2 kompensiert wurde und der Steckkontakt SK in den Gegensteckkontakt GS aufgenommen werden kann beziehungsweise mit diesem kontaktiert werden kann. Analog dazu ist gemäß Figur 2 der Winkelstecker WS an die Unterseite US der Hauptplatine HP angeschlossen.

Der Winkelstecker WS stellt somit einen Höhenausgleich zu dem Steckkontakt SK des Netzteils NT für beide Einbauhöhen EH1 und EH2 der Hauptplatine HP her. Dabei bleibt im Wesentlichen die Oberseite OS oder die Unterseite US der Hauptplatine HP in einem gleichbleibenden Abstand A2 zu der zweiten Mittelebene ME2 des Steckkontakts SK. In anderen Worten ausgedrückt bleibt diejenige Oberfläche, welche dem Anschlussbereich AB des Winkelsteckers im eingesteckten Zustand zugewandt ist und parallel zu der ersten Mittelebene ME1 der Hauptplatine HP verläuft, in dem gleichbleibenden Abstand A2 zu der zweiten Mittelebene ME2. Dies ist anhand der Figuren 1 und 2 gezeigt.

Um eine korrekte Kontaktierung des Netzteils NT mit der Hauptplatine HP zu verwirklichen beziehungsweise zu gewährleisten, ist der Winkelstecker WS wie anhand von Figur 4 dargestellt im Wesentlichen spiegelsymmetrisch bezüglich einer Symmetrieebene SE ausgebildet. Die Symmetrieebene SE ist dabei senkrecht zu der zweiten Mittelebene ME2 des Steckkontakts SK und senkrecht zur Steckrichtung des Netzteils NT (in Figur 4 gestrichelt dargestellt) angeordnet. Dadurch ist es möglich, dass der Winkelstecker WS sowohl an die Unterseite US als auch an die Oberseite OS der Hauptplatine HP angeschlossen werden kann und eine korrekte elektrische Verbindung zwischen dem Netzteil NT und der Hauptplatine HP hergestellt werden kann. Korrekt bedeutet in diesem Fall, dass Leitungen, Kontakte oder Pins des Steckkontakts SK des Netzteils NT mit den entsprechenden Kontakten, Leitungen oder Pins der Hauptplatine HP im Kontaktbereich KB über den Winkelstecker WS verbunden sind.

Die Anordnung AO ermöglicht es, dass das Netzteil NT mit dem Steckkontakt SK direkt an die Hauptplatine HP angeschlossen werden kann. Damit ist das eingangs beschriebene Hot Plugging möglich. Dabei muss unabhängig von der ersten oder zweiten Einbauhöhe EH1 beziehungsweise EH2 nur ein Winkelstecker WS vorgesehen werden. Es müssen keine weiteren Steckverbinder bereitgestellt werden, um die verschiedenen Einbauhöhen EH1 und EH2 der Hauptplatine HP für einen Direktanschluss an das Netzteil NT vorzubereiten.

Wie anhand der Figuren 1 und 2 zu sehen ist, ist der Grundkörper GK stufenförmig mit einer Stufe S ausgestaltet. Die Stufe S ist im eingesteckten Zustand des Winkelsteckers WS formschlüssig an der Hauptplatine HP angeordnet. Dadurch ist es möglich, dass beim Einstecken des Steckkontakts SK des Netzteils NT in den Gegensteckkontakt GS des Winkelsteckers WS Kräfte in einer Einsteckrichtung ER im Wesentlichen parallel zu der ersten Mittelebene ME1 von der Hauptplatine HP aufgenommen werden können, so dass diese Kräfte nicht vollständig auf den Anschlussbereich AB des Winkelsteckers WS und den Kontaktbereich KB der Hauptplatine HP übertragen werden.

Die konstruktive Ausgestaltung des Winkelsteckers WS und des Netzteils NT sowie die elektrische Verbindung zwischen dem Anschlussbereich AB und dem Gegensteckkontakt GS ist lediglich beispielhaft zu verstehen. Andere konstruktive Ausgestaltungen sind möglich. Gemäß Figur 1 gleicht der Winkelstecker WS den Versatz ausgehend von der ersten Mittelebene ME1 in einer ersten Richtung nach oben zu der zweiten Mittelebene ME2 des Steckkontakts SK aus. Gemäß Figur 2 wird dieser Versatz ausgehend von der ersten Mittelebene ME1 in einer zu der ersten Richtung entgegengesetzten zweiten Richtung nach unten ausgeglichen. Entsprechend einer alternativen, konstruktiven Ausgestaltung des Winkelsteckers WS können die beiden Richtungen auch vertauscht sein.

### Bezugszeichenliste

- A1: erster Abstand
- A2: zweiter Abstand
- AB: Anschlussbereich
- AO: Anordnung
- D: Dicke
- EH1: erste Einbauhöhe
- EH2: zweite Einbauhöhe
- ER: Einsteckrichtung
- GB: Gehäuseboden
- GK: Grundkörper
- GS: Gegensteckkontakt
- HP: Hauptplatine
- KB: Kontaktbereich
- L: Leitung
- ME1: erste Mittelebene
- ME2: zweite Mittelebene
- NT: Netzteil
- OS: Oberseite
- S: Stufe
- SE: Symmetrieebene
- SK: Steckkontakt
- US: Unterseite
- WS: Winkelstecker

## Patentansprüche

1. Anordnung (AO) für ein Computersystem, aufweisend
- ein Einschubgehäuse mit einem Gehäuseboden (GB);
- ein an dem Gehäuseboden (GB) angeordnetes Netzteil (NT) mit einem Steckkontakt (SK);
- eine innerhalb des Einschubgehäuses parallel zu dem Gehäuseboden (GB) angeordnete Hauptplatine (HP); und
- einen Winkelstecker (WS), welcher zum Anschluss des Netzteiles (NT) an die Hauptplatine (HP) einen Gegensteckkontakt (GS) und einen Anschlussbereich (AB) aufweist, **dadurch gekennzeichnet dass** der Winkelstecker (WS) beim Anschluss an die Hauptplatine (HP) mit dem Anschlussbereich (AB) in einer ersten Einbauhöhe (EH1) der Hauptplatine (HP) an einer Oberseite (OS) der Hauptplatine (HP) und in einer zweiten Einbauhöhe (EH2) der Hauptplatine (HP) in unterschiedlicher Ausrichtung, im Wesentlichen um 180° verdreht an einer Unterseite (US) der Hauptplatine (HP) angeschlossen ist, so dass jeweils ein Höhenausgleich bezüglich einer ersten Mittelebene (ME1) der Hauptplatine (HP) zu einer zweiten Mittelebene (ME2) des Steckkontakts (SK) des Netzteils (NT) hergestellt wird, wobei die Einbauhöhen (EH1, EH2) auf den jeweiligen Abstand der Hauptplatine (HP) zu dem Gehäuseboden (GB) in Normalenrichtung einer Erstreckungsebene der Hauptplatine (HP) bezogen sind.

2. Anordnung (AO) nach Anspruch 1, wobei die Hauptplatine (HP) zum Anschluss des Winkelsteckers (WS) einen Kontaktbereich (KB), insbesondere metallisierte Öffnungen, aufweist, welcher an der Oberseite (OS) und an der Unterseite (US) der Hauptplatine (HP) von dem Anschlussbereich (AB) des Winkelsteckers (WS) elektrisch kontaktiert werden kann.

3. Anordnung (AO) nach einem der Ansprüche 1 oder 2, wobei der Anschlussbereich (AB) des Winkelsteckers (WS) zum Anschluss an die Hauptplatine (HP) Einpresskontakte, insbesondere Pressfit-Kontakte aufweist.

4. Anordnung (AO) nach einem der Ansprüche 1 bis 3, wobei der Gegensteckkontakt (GS) des Winkelsteckers (WS) zur Aufnahme des Steckkontakts (SK) des Netzteils (NT) Federkontakte, insbesondere eine Federkontaktleiste, aufweist.

5. Anordnung (AO) nach einem der Ansprüche 1 bis 4, wobei der Steckkontakt (SK) des Netzteils (NT) wenigstens eine Kontaktzunge aufweist, insbesondere eine Goldkontaktzunge.

6. Anordnung (AO) nach einem der Ansprüche 1 bis 5, wobei der Winkelstecker (WS) spiegelsymmetrisch ausgebildet ist.

## Claims

1. Assembly (AO) for a computer system, comprising
- a plugin housing with a housing base (GB);
- a power supply (NT) arranged on the housing base (GB) with a plug contact (SK);
- a motherboard (HP) arranged within the plugin housing in parallel to the housing base (GB); and
- an angle plug (WS) which comprises a mating plug contact (GS) and a connection region (AB) for connecting the power supply (NT) to the motherboard (HP),
**characterized in that**
the angle plug (WS), when connecting to the motherboard (HP), is connected with the connection region (AB) in a first installation height (EH1) of the motherboard (HP) to a top side (OS) of the motherboard (HP) and in a second installation height (EH2) of the motherboard (HP) in a different orientation, substantially distorted by 180°, to an underside (US) of the motherboard (HP), so that in each case a height compensation with respect to a first center plane (ME1) of the motherboard (HP) to a second center plane (ME2) of the plug contact (SK) of the power supply (NT) is established, wherein the installation heights (EH1, EH2) are referred to the respective distance of the motherboard (HP) to the housing base (GB) in normal direction of an extension plane of the motherboard (HP).

2. Assembly (AO) according to claim 1, wherein the motherboard (HP) comprises a contact region (KB), in particular metal openings, for connecting the angle plug (WS), which can be electrically contacted by the connection region (AB) of the angle plug (WS) at the top side (OS) and at the underside (US) of the motherboard (HP) .

3. Assembly (AO) according to one of claims 1 or 2, wherein the connection region (AB) of the angle plug (WS) comprises press-in contacts, in particular press-fit contacts, for connecting to the motherboard (HP).

4. Assembly (AO) according to one of claims 1 to 3, wherein the mating plug contact (GS) of the angle plug (WS) comprises spring contacts, in particular a spring contact strip, for receiving the plug contact (SK) of the power supply (NT).

5. Assembly (AO) according to one of claims 1 to 4, wherein the plug contact (SK) of the power supply (NT) comprises at least one contact tongue, in particular a gold contact tongue.

6. Assembly (AO) according to one of claims 1 to 5, wherein the angle plug (WS) is configured mirror-symmetrically.

## Revendications

1. Agencement (AO) pour un système informatique, présentant
- un boîtier en tiroir muni d'un fond de boîtier (GB) ;
- un bloc secteur (NT) disposé sur le fond de boîtier (GB), muni d'une fiche de contact (SK) ;
- une platine principale (HP) disposée à l'intérieur du boîtier en tiroir, parallèlement au fond de boîtier (GB) ; et
- un connecteur coudé (WS) lequel, pour le raccordement du bloc secteur (NT) à la platine principale (HP), présente une contre-fiche de contact (GS) et une zone de connexion (AB),
**caractérisé en ce que**
le connecteur coudé (WS), lors du raccordement à la platine principale (HP) par la zone de connexion (AB), est raccordé sur un côté supérieur (OS) de la platine principale (HP) dans une première hauteur de montage (EH1) de la platine principale (HP) et **en ce que**, dans une seconde hauteur de montage (EH2) de la platine principale (HP), il est raccordé sur un côté inférieur (US) de la platine principale (HP) en orientation différente, en étant essentiellement tourné de 180°, de sorte que respectivement une compensation en hauteur concernant un premier plan médian (ME1) de la platine principale (HP) est établie par rapport à un deuxième plan médian (ME2) de la fiche de contact (SK) du bloc secteur (NT), les hauteurs de montage (EH1, EH2) faisant référence à l'écart respectif de la platine principale (HP) par rapport au fond de boîtier (GB) en direction normale d'un plan d'étendue de la platine principale (HP).

2. Agencement (AO) selon la revendication 1, la platine principale (HP), pour le raccordement du connecteur coudé (WS), présentant une zone de contact (KB), notamment des ouvertures métallisées, laquelle peut être mise électriquement en contact sur le côté supérieur (OS) et sur le côté inférieur (US) de la platine principale (HP) par la zone de connexion (AB) du connecteur coudé (WS).

3. Agencement (AO) selon l'une quelconque des revendications 1 ou 2, la zone de connexion (AB) du connecteur coudé (WS) présentant des contacts à insertion, notamment des contacts à ajustement par pression.

4. Agencement (AO) selon l'une quelconque des revendications 1 à 3, la contre-fiche de contact (GS) du connecteur coudé (WS), pour le logement de la fiche de contact (SK) du bloc secteur (NT), présentant des contacts à ressort, notamment une barrette de contacts à ressort.

5. Agencement (AO) selon l'une quelconque des revendications 1 à 4, la fiche de contact (SK) du bloc secteur (NT) présentant au moins une languette de contact, notamment une languette de contact en or.

6. Agencement (AO) selon l'une quelconque des revendications 1 à 5, le connecteur coudé (WS) étant réalisé avec symétrie de miroir.
